# EUROPEAN PATENT APPLICATION

(11) **EP 4 629 751 A1**
(43) Date of publication of application: **08.10.2025**
(21) Application number: 23897368.9
(22) Date of filing: 02.11.2023
(51) Int. Cl.: H05K 1/02, H01L 23/12, H05K 1/18

(54) **SUBSTRATE**

(30) Priority: 28.11.2022 JP 2022189480
(71) Applicant: OMRON Corporation, Kyoto 600-8530 (JP)
(72) Inventor: MISHIMA, Junya, Kyoto-shi, Kyoto 600-8530 (JP); AITA, Fumiji, Kyoto-shi, Kyoto 600-8530 (JP); SATO, Yoshiyuki, Kyoto-shi, Kyoto 600-8530 (JP)
(74) Representative: HGF
(86) International application number: PCT/JP2023/039588
(87) International publication number: WO 2024/116713

(57) **Abstract**

According to the present disclosure, heat dissipation of an electronic component connected to a pad is improved while generation of voids in solder on the pad is suppressed. A substrate according to the present disclosure includes a plate-shaped base, a pad provided on one main surface of the base and containing metal, and a solder resist provided on a part of a surface of the pad. A plurality of holes penetrating the pad and the base in a thickness direction of the base is formed at a position different from a position where the solder resist is provided on the pad. The solder resist extends between the plurality of holes without overlapping the plurality of holes and is in contact with an edge of the pad in a plan view seen along the thickness direction of the base.

## Description

### TECHNICAL FIELD

The present disclosure relates to a substrate including a pad capable of dissipating heat generated in an electronic component.

### BACKGROUND ART

Conventionally, as this type of substrate, for example, a printed wiring board recited in Patent Document 1 is known. The printed wiring board includes a pad divided into a plurality of divided pads by solder resist. Electronic components can be connected to the pads via solder. Heat generated in the electronic component is dissipated via the solder and the pad.

### PRIOR ART DOCUMENT

### PATENT DOCUMENT

Patent Document 1: JP-A-2012-099682

### SUMMARY OF THE INVENTION

### PROBLEMS TO BE SOLVED BY THE INVENTION

The printed wiring board of Patent Document 1 still has room for improvement from the viewpoint of improving heat dissipation of the electronic component connected to the pad while suppressing generation of voids in the solder on the pad.

Therefore, an object of the present disclosure is to solve the above problems, and to improve heat dissipation of an electronic component connected to a pad while suppressing generation of voids in solder on the pad.

### SOLUTIONS TO THE PROBLEMS

A substrate according to the present disclosure includes:
a plate-shaped base;
a pad provided on one main surface of the base and containing metal; and
a solder resist provided on a part of a surface of the pad;
wherein
a plurality of holes penetrating the pad and the base in a thickness direction of the base is formed at a position different from a position where the solder resist is provided on the pad, and
the solder resist extends between the plurality of holes without overlapping the plurality of holes and is in contact with an edge of the pad in a plan view seen along the thickness direction of the base.

### EFFECTS OF THE INVENTION

According to the present disclosure, it is possible to improve heat dissipation of an electronic component connected to a pad while suppressing generation of voids in solder on the pad.

### BRIEF DESCRIPTION OF THE DRAWINGS

[Fig. 1] Fig. 1 is a plan view of a substrate according to an embodiment of the present disclosure.
[Fig. 2] Fig. 2 is a cross-sectional view taken along line II-II of Fig. 1.
[Fig. 3] Fig. 3 is a cross-sectional view corresponding to Fig. 2, illustrating a module according to the embodiment of the present disclosure.
[Fig. 4] Fig. 4 is a flowchart illustrating a process of manufacturing the substrate of Fig. 1 and a process of mounting an electronic component on the substrate.
[Fig. 5] Fig. 5 is an enlarged plan view illustrating a first modification of a pad on the substrate of Fig. 1.
[Fig. 6] Fig. 6 is a plan view of the substrate according to the embodiment of the present disclosure, and is a view illustrating a second modification of the pad.
[Fig. 7] Fig. 7 is a plan view illustrating a third modification of the pad on the substrate in Fig. 6.
[Fig. 8] Fig. 8 is a plan view illustrating a fourth modification of the pad on the substrate in Fig. 6.
[Fig. 9] Fig. 9 is a plan view illustrating a fifth modification of the pad on the substrate in Fig. 6.
[Fig. 10] Fig. 10 is a plan view illustrating a sixth modification of the pad on the substrate in Fig. 6.

### DETAILED DESCRIPTION

### <Knowledge Underlying the Present Disclosure>

As a result of intensive studies to improve heat dissipation of an electronic component connected to a pad while suppressing generation of voids in solder on the pad, the present inventors have obtained the following findings.

In the printed wiring board described in Patent Document 1, solder resist is disposed on a part of a pad on one main surface. The pad is divided into a plurality of divided pads by the solder resist. In a process of mounting an electronic component on the printed wiring board, first, solder paste containing solder is applied onto the pad. Next, the electronic component is mounted on a substrate so as to be in contact with the solder paste, and reflow is performed. The reflow melts the solder paste. At this time, the solder in the solder paste provided on the solder resist flows onto the divided pad on which the solder resist is not disposed. As a result, each divided pad of the printed wiring board and the electronic component are connected by the solder.

Heat generated in the electronic component is conducted to the pad via the solder. The heat conducted to the pad is dissipated to the other main surface (surface opposite to the surface on which the pad is provided) of the printed wiring board through a through hole penetrating the printed wiring board at a position of the pad. In other words, the through hole constitutes a heat dissipation path from the pad. In a conventional printed wiring board, a through hole is formed in a region where solder resist is disposed. In this case, since heat dissipation of the through hole is low, heat is likely to be accumulated in the pad. As a result, heat dissipation of the electronic component might be deteriorated.

Therefore, as a result of intensive studies, the present inventors have arrived at extending solder resist to an edge of a pad and forming a hole penetrating the pad and a base at a position different from a position of the pad where the solder resist is provided. Since the hole is located at the position different from the position where the solder resist is provided, the hole is filled with solder in solder paste during reflow. As a result, heat generated in an electronic component is dissipated to the other main surface of the substrate via the solder disposed inside a hole to improve heat dissipation of the electronic component. Based on this new finding, the present inventors have reached the following disclosure.

In the following, an embodiment of the present disclosure will be described in detail with reference to the drawings. Note that this embodiment does not limit the present disclosure. In the drawings, substantially the same members are denoted by the same reference numerals.

Although in the following description, for convenience of description, terms indicating directions such as "upper" and "lower" are used, these terms do not limit a use state or the like of a substrate and a module according to the present disclosure.

### <Embodiment>

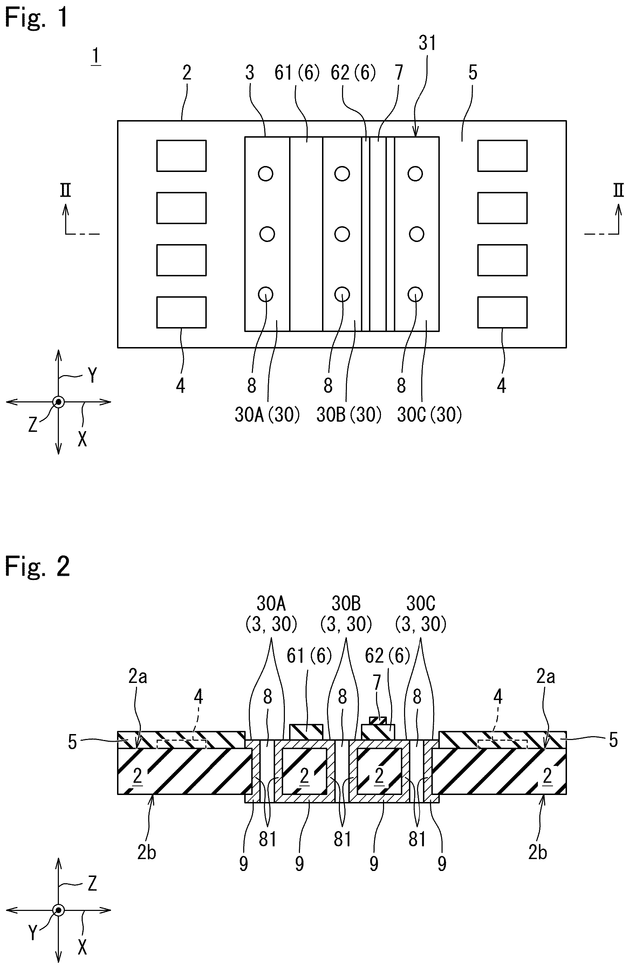

A substrate according to an embodiment of the present disclosure will be described with reference to Figs. 1 and 2. Fig. 1 is a plan view of the substrate according to the embodiment of the present disclosure. Fig. 2 is a cross-sectional view taken along line II-II of Fig. 1.

Electronic components such as a power semiconductor and a large-scale integrated circuit (LSI) can be mounted on a substrate 1. In the present specification, the "substrate" includes both a printed wiring board on which printed wiring is formed and on which no electronic component is mounted and a printed circuit board on which an electronic component is mounted on the printed wiring board. In other words, the electronic component may or may not be already mounted on the substrate in the present specification.

As illustrated in Figs. 1 and 2, the substrate 1 of the present embodiment is a printed wiring board. The substrate 1 includes a plate-shaped base 2 having one main surface 2a and the other main surface 2b, and pads 3 and 4 provided on the one main surface 2a and containing metal. The one main surface 2a is covered with a solder resist 5 excluding the pads 3 and 4. Among the pads 3 and 4, the pad 3 corresponds to the pad in the present disclosure. A solder resist 6 is provided on a part of a surface 30 of the pad 3. In other words, the solder resist 5 is provided on the one main surface 2a of the base 2, and the solder resist 6 is provided on the pad 3. A plurality of holes 8 penetrating the pad 3 and the base 2 is formed at a position different from the position where the solder resist 6 is provided on the pad 3.

As illustrated in Fig. 1, the base 2 of the present embodiment has a rectangular shape in plan view as seen along a thickness direction of the base 2. In the following description, a longitudinal direction of the base 2 in plan view may be referred to as an X direction, a short direction of the base 2 in plan view may be referred to as a Y direction, and the thickness direction of the base 2 may be referred to as a Z direction. The X direction and the Y direction are orthogonal to each other, and the Z direction is orthogonal to both the X direction and the Y direction.

As illustrated in Fig. 2, the base 2 of the present embodiment is an insulating layer in a copper-clad laminate for a double-sided substrate. In other words, the substrate 1 of the present embodiment is a single-layer substrate. A material of the insulating layer is resin, glass, ceramic, or the like. The base 2 may have a laminated structure including two or more insulating layers and a conductive layer disposed between these insulating layers to constitute wiring. In other words, the substrate 1 may be a multilayer substrate.

Printed wiring may be provided on the one main surface 2a and the other main surface 2b of the base 2, and on a conductive layer in a case where the substrate 1 is a multilayer substrate. The base 2 may be provided with a through hole, a via, and the like for connecting printed wiring at different positions in the Z direction. As shown in Fig. 1, the printed wiring provided on the one main surface 2a is covered with the solder resist 5.

As illustrated in Fig. 2, a pad 9 containing metal may be provided on the other main surface 2b. The pad 9 of the present embodiment at least partially overlaps the pad 3 provided on the one main surface 2a in the Z direction. In the present embodiment, the pad 3, the pad 9, and a plating layer 81 to be described later of the hole 8 are integrated.

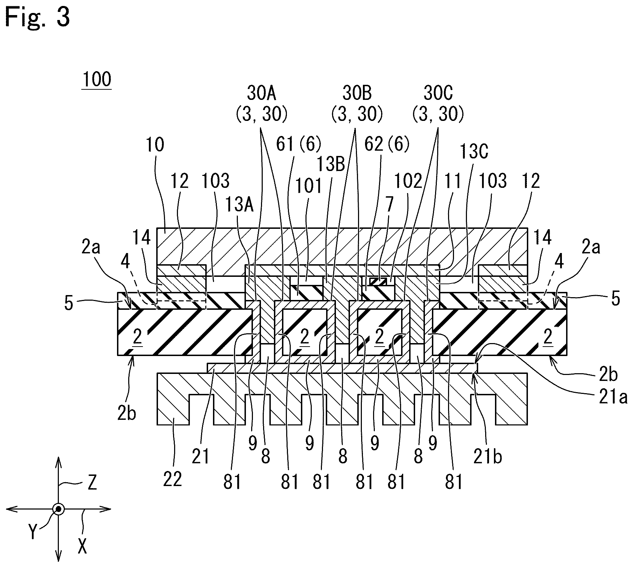

The pad 3 is connected to a heat dissipation portion 11 of an electronic component 10 (see Fig. 3) when the electronic component 10 is mounted on the substrate 1. The pad 3 may be connected to a wiring provided on the base 2 or may be away from the wiring. In other words, the pad 3 may or may not be electrically connected to the circuit formed on the substrate 1.

As illustrated in Fig. 1, the pad 3 of the present embodiment has a rectangular shape in plan view. Note that the shape of the pad 3 in plan view may be a circle, an ellipse, a polygon, or the like.

The pad 4 is connected to a terminal 12 of the electronic component 10 (see Fig. 3) when the electronic component 10 is mounted on the substrate 1. As a result, the terminal 12 of the electronic component 10 and the circuit formed on the substrate 1 are electrically connected. In the present embodiment, eight pads 4 are disposed so as to be adjacent to the pad 3 in the X direction.

A material of the pads 3, 4, and 9 is, for example, copper, gold, silver, palladium, nickel, platinum, or an alloy thereof. The pads 3, 4, and 9 of the present embodiment are copper foils of a copper-clad laminate.

A solder resist 6 is provided on a part of a surface 30 of the pad 3. Among the solder resists 5 and 6, the solder resist 6 corresponds to the solder resist in the present disclosure. Molten solder is less likely to adhere to the solder resist 6.

As illustrated in Fig. 1, the solder resist 6 extends between the plurality of holes 8 without overlapping the plurality of holes 8 in plan view, and is in contact with an edge 31 of the pad 3 at least at one place. The solder resist 6 of the present embodiment includes two extending resists 61 and 62 extending along one direction without intersecting each other in plan view. The extending resists 61 and 62 have linear shapes extending in the Y direction in plan view and are parallel to each other. Opposite ends of each of the extending resists 61 and 62 are in contact with the edges 31 of the pad 3 in plan view. In other words, each of the extending resists 61 and 62 extends, at its opposite ends, to the edges 31 of the pad 3.

The number of the extending resists is not limited to two, and may be one or three or more. In addition, each extending resist only needs to extend along one direction as a whole, and may have, for example, a wavy line shape or a bent linear shape. In addition, in a case where a plurality of extending resists is provided, these extending resists may not be parallel to each other as long as each extending resist extends along one direction.

As illustrated in Fig. 2, a mark layer 7 is provided on the extending resist 62. The mark layer 7 constitutes at least a part of a mark displayed in plan view. The mark may be a line, a figure, a character, a number, a symbol, a dotted recognition code, a barcode, a two-dimensional barcode, a logo, or the like.

The mark layer 7 may be provided in an entire region of the extending resist 62 in plan view, or may be provided only in a part of the region. As illustrated in Fig. 1, the mark layer 7 of the present embodiment is provided linearly over an entire length of the extending resist 62 in the Y direction. In other words, opposite ends of the mark layer 7 are in contact with the edges 31 of the pad 3 in plan view. A width of the mark layer 7 of the present embodiment in the X direction is smaller than a width of the extending resist 62 in the X direction.

A material of the mark layer 7 is resin, ceramic, or the like that repels molten solder. The mark layer 7 of the present embodiment is a silk pattern.

A region of the surface 30 of the pad 3 where the solder resist 6 is not disposed is sectioned into a plurality of non-resist regions 30A to 30C by the solder resist 6. In the present embodiment, a region where the solder resist 6 is not disposed is sectioned into three non-resist regions 30A to 30C by the two extending resists 61 and 62. In the present embodiment, a total area of the non-resist regions 30A to 30C in plan view is larger than a total area of the solder resist 6 in plan view.

Since the extending resists 61 and 62 extend along the Y direction, the non-resist regions 30A to 30C are not sectioned by the solder resist 6 in the Y direction. As a result, in each of the non-resist regions 30A to 30C, heat can be conducted in the Y direction over an entire length of the pad 3 in the Y direction.

In plan view of the pad 3, the two extending resists 61 and 62 and the three non-resist regions 30A to 30C are alternately positioned in a direction intersecting an extending direction of the extending resists 61 and 62, for example, in the Y direction.

The plurality of holes 8 is formed at a position different from the position where the solder resist 6 is provided on the pad 3. The plurality of holes 8 is formed in at least two of the non-resist regions 30A to 30C. As illustrated in Fig. 2, each hole 8 penetrates the pad 3 and the base 2 in the Z direction. The hole 8 of the present embodiment further penetrates the pad 9 provided on the other main surface 2b.

As illustrated in Fig. 1, the hole 8 of the present embodiment is a circular through hole in plan view, and three holes are formed in each of the non-resist regions 30A to 30C. As illustrated in Fig. 2, the plating layer 81 is provided on an inner surface of the hole 8.

As illustrated in Fig. 1, the holes 8 of the present embodiment are aligned in the X direction and the Y direction. Note that the plurality of holes 8 is not limited to the above, and may be aligned in only one of the X direction and the Y direction, or may not be aligned.

The number of the holes 8 in each of the non-resist regions 30A to 30C may be one or more and may be different from each other. As long as the hole 8 is formed in at least two non-resist regions, there may be a non-resist region in which the hole 8 is not formed.

### <Method for Manufacturing Substrate>

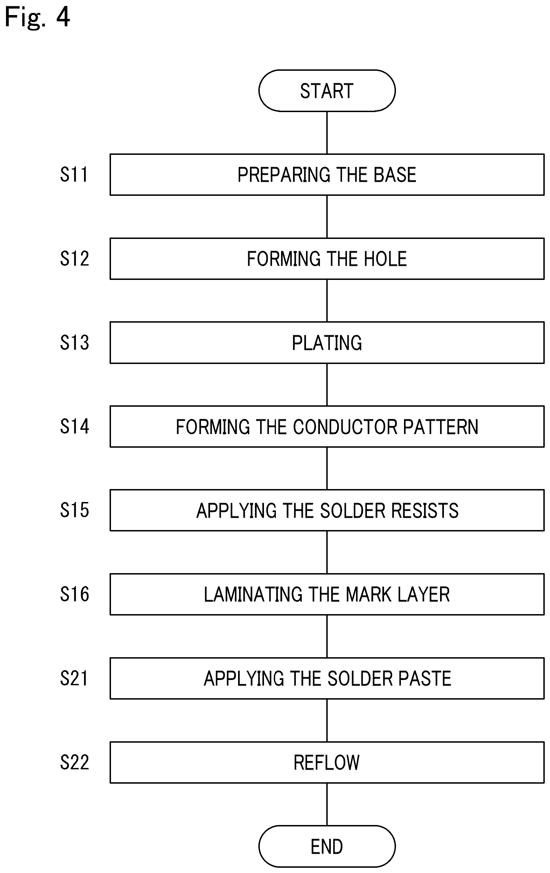

An example of a method for manufacturing the substrate according to the present disclosure will be described with reference to Fig. 4. Fig. 4 is a flowchart illustrating a process of manufacturing the substrate of Fig. 1 and a process of mounting an electronic component on the substrate.

First, the base 2 is prepared (step S11). The base 2 is, for example, a copper-clad laminate for a double-sided substrate in which a copper foil is provided on entire surfaces of the one main surface 2a and the other main surface 2b. The copper foil constitutes the pads 3, 4, and 9, and the printed wiring on the one main surface 2a and the other main surface 2b.

Next, the hole 8 is formed in the base 2 (step S12). The hole 8 is formed by, for example, grinding with a drill or laser machining.

Next, the plating layer 81 is formed inside the hole 8 (step S13). The plating layer 81 is formed by, for example, electroless copper plating.

Next, the copper foil on the one main surface 2a and the other main surface 2b is etched to form a conductor pattern constituting the printed wiring (step S14). The etching is performed, for example, by bonding a dry film to the one main surface 2a and the other main surface 2b, curing a region of the dry film excluding the conductor pattern, and then exposing the base 2 to an etching solution. In this case, the cured dry film is removed after etching.

Next, the solder resists 5 and 6 are provided on the one main surface 2a and the other main surface 2b excluding the non-resist regions 30A to 30C and the regions of the pads 4 and 9 (step S15). The solder resists 5 and 6 are provided by, for example, screen printing, spray coating, or curtain coating.

Next, the mark layer 7 is laminated on the extending resist 62 (step S16). The mark layer 7 is printed by silk printing, for example.

### <Method for Mounting Electronic Component>

Next, an example of the process of mounting the electronic component 10 on the substrate 1 will be described with reference to Figs. 3 and 4. Fig. 3 is a cross-sectional view corresponding to Fig. 2, illustrating a module according to the embodiment of the present disclosure. As illustrated in Fig. 3, the electronic component 10 mounted on the substrate 1 has the heat dissipation portion 11 and the terminal 12 provided on a surface. The heat dissipation portion 11 is connectable to the pad 3, and the terminal 12 is connectable to the pad 4.

In the process of mounting the electronic component 10, first, solder paste containing solder is applied to the pads 3 and 4 (step S21). In this example, the solder paste is applied to an entire surface of the pad 3. In other words, the solder paste is applied onto the non-resist regions 30A to 30C, the solder resist 6, and the mark layer 7. The coating is performed by, for example, screen printing.

Next, the reflow is performed with the electronic component 10 mounted on the substrate 1 (step S22). The solder contained in the solder paste is melted by the reflow. Since the solder resist 6 and the mark layer 7 repel the molten solder, the solder contained in the solder paste on the solder resist 6 and the mark layer 7 flows to the non-resist regions 30A to 30C. Flux, moisture, and the like contained in the solder paste are volatilized during the reflow. As a result, spaces 101 and 102 are formed between the heat dissipation portion 11 and the solder resist 6.

A part of the molten solder on the non-resist regions 30A to 30C enters the hole 8. The rest of the molten solder remains in the non-resist regions 30A to 30C. Gases generated by volatilization of the flux, the moisture, and the like contained in the solder paste are released to the outside of the pad 3 through the spaces 101 and 102.

When the solder paste is applied onto the non-resist regions 30A to 30C and the solder resist 6, the solder in the solder paste applied onto the solder resist 6 flows into each of the non-resist regions 30A to 30C in addition to the solder in the solder paste applied thereon. As a result, since an amount of molten solder on the non-resist regions 30A to 30C increases, a possibility of shortage of solder on the non-resist regions 30A to 30C due to entry of the solder into the hole 8 can be reduced. In addition, a solder filling rate in the plurality of holes 8 can be improved as compared with a configuration in which the solder resist 6 is not provided.

In the present specification, "filling" means that an object (e.g., solder) is disposed in all or a part of a certain space (e.g., an internal cavity of the hole). The filling rate is, for example, a ratio obtained by dividing a total volume of the solder disposed in the internal cavity of the hole 8 by a total volume of the internal cavity of the hole 8.

The shorter a distance between the solder resist 6 and the hole 8 in plan view, the more easily the solder enters the hole 8 due to a flow of the solder contained in the solder paste on the solder resist 6. On the other hand, in a case where the solder resist 6 and the hole 8 are in contact with each other in plan view, the solder resist 6 may hinder entry of the solder into the hole 8. Therefore, in the embodiment of the present disclosure, each hole 8 is away from, i.e., not in contact with, the solder resist 6 in plan view.

A module 100 in which the electronic component 10 is mounted on the substrate 1 will be described with reference to Fig. 3. The module 100 may further include a heat dissipation sheet 21 provided on the pad 9 on the other main surface 2b and a heat sink 22 connected to the heat dissipation sheet 21.

The electronic component 10 is mounted on the substrate 1 by, for example, the above-described mounting process. In the module 100, the heat dissipation portion 11 of the electronic component 10 and the pad 3 of the substrate 1 sandwich solders 13A to 13C and the solder resist 6 in the Z direction.

The heat dissipation portion 11 of the electronic component 10 and the non-resist regions 30A to 30C of the pad 3 are connected by the solidified solders 13A to 13C. Each of the solders 13A to 13C is disposed between the pad 3 and the heat dissipation portion 11 and extends inside the hole 8. In other words, the holes 8 are filled with the solders 13A to 13C.

Heat generated in the electronic component 10 is conducted to the other main surface 2b of the base 2 via the heat dissipation portion 11, the solders 13A to 13C, the pad 3, and the plating layer 81 of the hole 8. Although in the example illustrated in Fig. 3, an amount of the solder filled in each hole 8 is the same, it may be different. In addition, as long as at least one of the plurality of holes 8 is filled with solder, there may be a hole 8 that is not filled with solder.

The terminal 12 and the pad 4 are connected by a solder 14 derived from the solder paste applied to the pad 4. As a result, the electronic component 10 and the circuit of the substrate 1 are electrically connected.

The heat dissipation sheet 21 of the present embodiment has one main surface 21a in contact with the pad 9 and the other main surface 21b opposite to the one main surface 21a. The heat sink 22 is in contact with the other main surface 21b. As a result, heat generated in the electronic component 10 is conducted to the heat sink 22 via the heat dissipation portion 11, the solders 13A to 13C, the pad 3, the plating layer 81 of the hole 8, the pad 9, and the heat dissipation sheet 21, and is dissipated to the outside of the module 100.

According to the substrate 1 of the present embodiment, when solder paste containing solder is applied onto the solder resist 6 and the solder is melted by the reflow, the solder flows from the position on the solder resist 6 to the non-resist regions 30A to 30C. A part of the solder flowing to the non-resist regions 30A to 30C enters the plurality of holes 8 and solidifies inside the plurality of holes 8. Heat dissipation of the holes 8 filled with the solders 13A to 13C is higher than heat dissipation of the holes not filled with the solder. Therefore, since an amount of heat conducted from the one main surface 2a to the other main surface 2b of the base 2 via the hole 8 increases, the heat dissipation of the electronic component can be improved.

According to this configuration, molten solder flows out from the solder resist 6, whereby the spaces 101 and 102 are formed between the electronic component 10 connected to the pad 3 and the solder resist 6. Since the solder resist 6 extends to the edge 31 of the pad 3, the spaces 101 and 102 communicate with the outside of the pad 3. Gas generated when the solder melts can be discharged to the outside of the pad 3 through the spaces 101 and 102. Accordingly, it is possible to improve the heat dissipation of the electronic component 10 connected to the pad 3 while suppressing generation of voids in the solders 13A to 13C on the pad 3.

In a case where the plurality of holes 8 is formed only in one non-resist region, molten solder may enter the plurality of holes 8, so that shortage of solder on the one non-resist region might occur. The shortage of solder on the one non-resist region causes generation of voids. On the other hand, according to the substrate 1 of the present embodiment, since the plurality of holes 8 is formed to be dispersed in the plurality of non-resist regions 30A to 30C, the number of the holes 8 formed in one non-resist region can be reduced. This can reduce the possibility of shortage of solder on each of the non-resist regions 30A to 30C. Accordingly, generation of voids in the solders 13A to 13C can be further suppressed.

In addition, according to the substrate 1 according to the present embodiment, since the plurality of extending resists 61 and 62 extends along one direction (e.g., in the Y direction,) on the pad 3 without intersecting each other, each of the non-resist regions 30A to 30C is not sectioned in the extending direction of the extending resist. Therefore, in the respective non-resist regions 30A to 30C and the solders 13A to 13C disposed thereon, heat is dispersed in the extending direction. Accordingly, in each of the non-resist regions 30A to 30C, it is possible to suppress deterioration of heat dissipation of the electronic component 10 due to concentration of heat in a part.

In the substrate 1 according to the present embodiment, the solder paste applied on the mark layer 7 is disposed at a position higher than the solder paste applied on the solder resist 6 in the thickness direction (e.g., in the Z direction) of the base 2. Therefore, the solder in the solder paste applied on the mark layer 7 flows more largely than the solder in the solder paste applied on the solder resist 6 when flowing to the non-resist regions 30A to 30C. Due to this large flow, molten solder easily enters the plurality of holes 8.

### <Modifications>

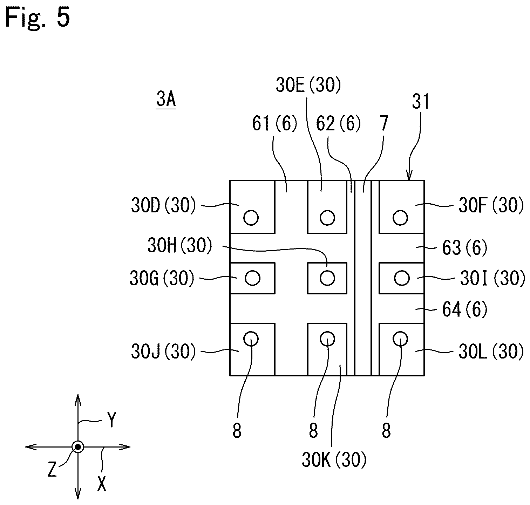

A first modification of the pad 3 according to the embodiment will be described with reference to Fig. 5. Fig. 5 is an enlarged plan view illustrating the first modification of the pad on the substrate of Fig. 1. A pad 3A illustrated in Fig. 5 and the pad 3 illustrated in Fig. 1 are different in arrangement of the solder resist 6. The remaining part is the same as or similar to the pad 3 described above, and thus description thereof may be omitted.

In the pad 3A illustrated in Fig. 5, the solder resist 6 includes two first extending resists 61 and 62 and two second extending resists 63 and 64. The first extending resists 61 and 62 of the present modification are the same as or similar to the extending resists 61 and 62 of the above-described embodiment. The first extending resists 61 and 62 extend along a first direction without intersecting each other in plan view, and are in contact with an edge 31 of the pad 3A at opposite ends. The first extending resists 61 and 62 of the present modification extend in parallel to each other along the Y direction. In other words, in the present modification, the Y direction corresponds to the first direction.

The second extending resists 63 and 64 extend along a second direction different from the first direction without intersecting each other in plan view, and are in contact with the edge 31 of the pad 3A at opposite ends. The second extending resists 63 and 64 of the present modification extend in parallel to each other along the X direction orthogonal to the Y direction. In other words, in the present modification, the X direction corresponds to the second direction. The two first extending resists 61 and 62 and the two second extending resists 63 and 64 intersect. In other words, the solder resist 6 is provided on the pad 3A in a lattice pattern.

A region of the surface 30 of the pad 3A where the solder resist 6 is not disposed is sectioned into nine non-resist regions 30D to 30L by the first extending resists 61 and 62 and the second extending resists 63 and 64. One hole 8 is formed in each of the non-resist regions 30D to 30L. The number of the holes 8 formed in each of the non-resist regions 30D to 30L is not limited to one.

Note that the first extending resists 61 and 62 and the second extending resists 63 and 64 may extend along the first direction or the second direction, and may not be parallel to each other. In addition, the first extending resists 61 and 62 and the second extending resists 63 and 64 may extend in different directions and may not be orthogonal to each other.

According to the substrate 1 including the pad 3A according to the first modification, solder flows into each hole 8 from more directions as compared with a configuration having only one of the first extending resists 61 and 62 and the second extending resists 63 and 64. For example, in a case of a configuration without the second extending resists 63 and 64, solder flows into the hole 8 sandwiched by the two first extending resists 61 and 62 from the two first extending resists 61 and 62 on opposite sides of the hole 8, i.e., from two directions. On the other hand, solder flows into the hole 8 surrounded by the two first extending resists 61 and 62 and the two second extending resists 63 and 64 from the two first extending resists 61 and 62 and the two second extending resists 63 and 64 surrounding the hole 8, i.e., from the four directions. As a result, molten solder easily enters the plurality of holes 8.

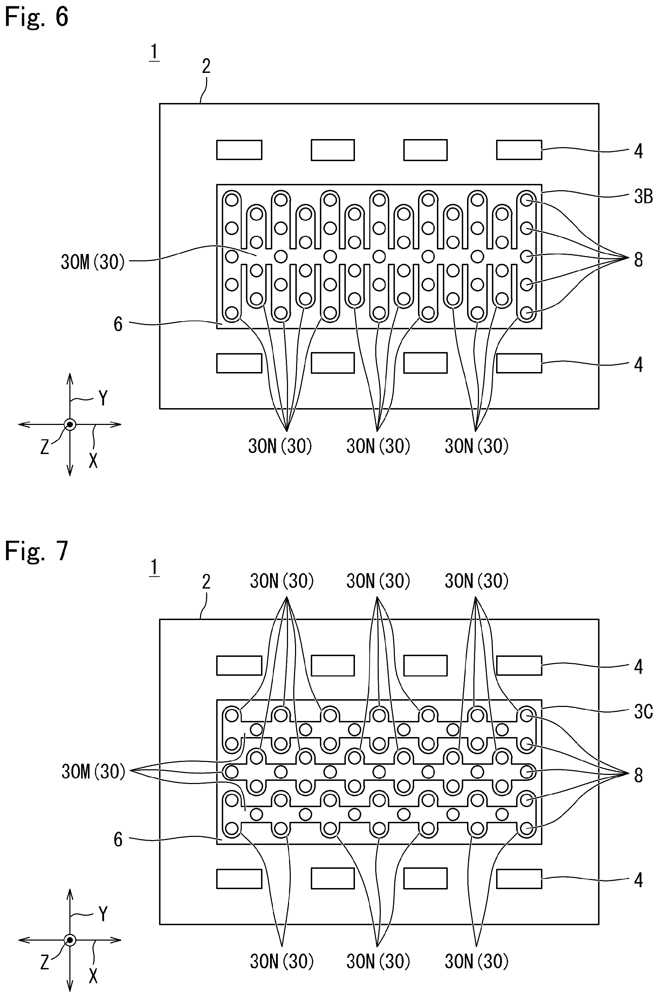

Fig. 6 is a plan view of the substrate according to the embodiment of the present disclosure, and is a view illustrating a second modification of the pad. In a substrate 1 illustrated in Fig. 6, eight pads 4 are disposed so as to be adjacent to a pad 3B in the Y direction.

In the pad 3B, a plurality of holes 8 is formed so as to extend along the Y direction and form a plurality of rows arranged in the X direction. In each row, the holes 8 are disposed at equal intervals. In the plurality of rows, a set of two rows is arranged in the X direction. In the two rows, the hole 8 in one row is deviated from the hole 8 in the other row in the Y direction. The hole 8 in one row of each set is aligned along the X direction, and the hole 8 in the other row of each set is also aligned along the X direction. In other words, the plurality of holes 8 also constitutes a plurality of rows arranged in the Y direction.

The pad 3B is provided with one non-resist region 30M extending along the X direction and a non-resist region 30N extending along the Y direction. In the non-resist region 30M, one row of the holes 8 among the plurality of rows arranged in the Y direction is disposed. In other words, a width of the non-resist region 30M in the Y direction is larger than a diameter of the hole 8. In the present modification, one non-resist region 30M extends at a central part of the pad 3B in the Y direction. Each of 13 non-resist regions 30N intersects with the non-resist region 30M and extends along the row of the holes 8 arranged in the X direction. The holes 8 constituting each of the rows arranged in the X direction are included in each non-resist region 30N in plan view.

A surface 30 of the pad 3B is covered with a solder resist 6 excluding the non-resist regions 30M and 30N. In other words, all the holes 8 are disposed in a region of the surface 30 that is not covered with the solder resist 6.

Fig. 7 is a plan view illustrating a third modification of the pad on the substrate in Fig. 6. As illustrated in Fig. 7, a pad 3C is provided with three non-resist regions 30M and a plurality of non-resist regions 30N intersecting with the respective non-resist regions 30M. In the present modification, two of a plurality of holes 8 forming a row arranged in the X direction are disposed in each non-resist region 30N.

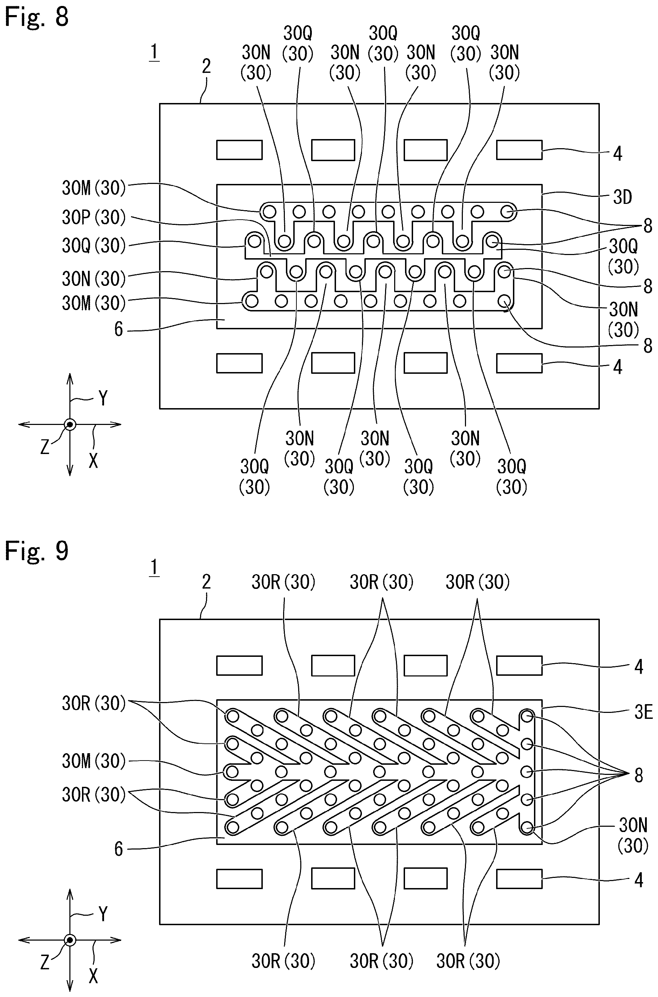

Fig. 8 is a plan view illustrating a fourth modification of the pad on the substrate in Fig. 6. As illustrated in Fig. 8, a pad 3D is provided with two non-resist regions 30M and a plurality of non-resist regions 30N extending in one direction along the Y direction from each of the non-resist regions 30M. Furthermore, the pad 3D is provided with a non-resist region 30P extending along the X direction and a non-resist regions 30Q extending from the non-resist region 30P along the Y direction.

A width of the non-resist region 30P in the Y direction is smaller than a diameter of a hole 8. In other words, the non-resist region 30P does not include the hole 8 in plan view. The holes 8 sandwiched between the non-resist region 30M and the non-resist region 30P in the Y direction are alternately disposed in the non-resist region 30N or the non-resist region 30Q in the X direction.

Fig. 9 is a plan view illustrating a fifth modification of the pad on the substrate in Fig. 6. As illustrated in Fig. 9, a pad 3E is provided with a plurality of non-resist regions 30R in addition to one non-resist region 30M and one non-resist region 30N. The non-resist region 30N intersects one end (right end in Fig. 9) of the non-resist region 30M. The non-resist region 30R extends from one of the non-resist regions 30M and 30N so as to be away from the non-resist region 30M in the Y direction as being away from the non-resist region 30N in the X direction. In the present modification, the plurality of non-resist regions 30R extends in parallel to each other.

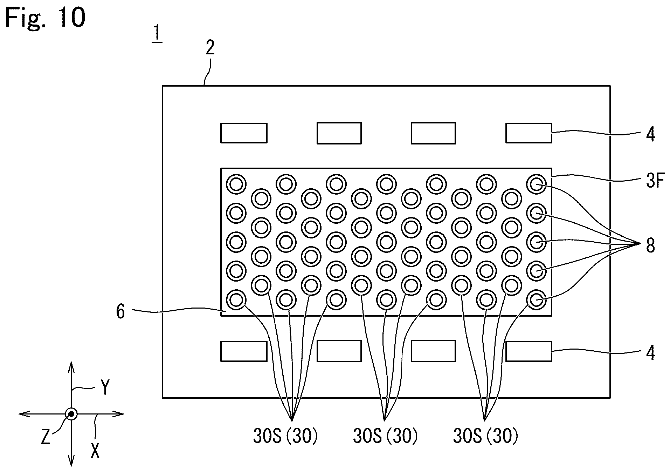

Fig. 10 is a plan view illustrating a sixth modification of the pad on the substrate in Fig. 6. As illustrated in Fig. 10, a pad 3F is provided with a plurality of non-resist regions 30S surrounding each hole 8. The non-resist region 30S has the same shape as the hole 8 in plan view.

Note that the present disclosure is not limited to the above embodiments, and can be implemented in various other modes. For example, although in the above description, the hole 8 is a circular through hole, the present disclosure is not limited thereto. Note that the shape of the hole 8 in plan view may be an ellipse, a polygon, or the like. For example, the shape of the hole 8 in plan view may be a rectangle extending in the extending direction of each of the non-resist regions 30A to 30C.

Although the present disclosure will be fully described in connection with the preferred embodiments with reference to the accompanying drawings, various changes and modifications will be apparent to those skilled in the art. Such variations and modifications are to be understood as being included within the scope of the present disclosure as set forth in the appended claims.

### <Aspects>

In the first aspect, a substrate including:
a plate-shaped base;
a pad provided on one main surface of the base and containing metal; and
a solder resist provided on a part of a surface of the pad;
wherein
a plurality of holes penetrating the pad and the base in a thickness direction of the base is formed at a position different from a position where the solder resist is provided on the pad, and
the solder resist extends between the plurality of holes without overlapping the plurality of holes and is in contact with an edge of the pad in a plan view seen along the thickness direction of the base.

In the second aspect, the substrate according to the first aspect, wherein
the solder resist is in contact with the edge of the pad at two or more places in the plan view,
a region of the surface of the pad where the solder resist is not disposed is sectioned into a plurality of non-resist regions by the solder resist, and
the plurality of holes is formed in at least two of the plurality of non-resist regions.

In the third aspect, the substrate according to the second aspect, wherein
the solder resist has a plurality of extending resists extending along one direction without intersecting each other in the plan view and being in contact with the edge of the pad at opposite ends, and
the plurality of extending resists and the plurality of non-resist regions are alternately positioned in the plan view.

In the fourth aspect, the substrate according to the second aspect, wherein
the solder resist includes:
a plurality of first extending resists extending along a first direction without intersecting each other in the plan view and being in contact with the edge of the pad at opposite ends; and
a plurality of second extending resists extending along a second direction different from the first direction without intersecting with each other in the plan view and being in contact with the edge of the pad at opposite ends, and
the plurality of first extending resists and the plurality of second extending resists intersect with each other.

In the fifth aspect, the substrate according to any one of the first to fourth aspects, wherein a mark layer constituting a mark is provided on the solder resist.

In the sixth aspect, a module including:
the substrate according to any one of the first to fifth aspects;
an electronic component mounted on the substrate and having a heat dissipation portion opposite to the pad; and
a solder disposed between the heat dissipation portion of the electronic component and the pad of the substrate and inside at least one of the plurality of holes to connect the heat dissipation portion and the pad.

### INDUSTRIAL APPLICABILITY

The substrate according to the present disclosure can improve heat dissipation of an electronic component connected to a pad while suppressing generation of voids in solder on the pad, and thus is useful for a substrate on which an electronic component such as a power semiconductor or an LSI is mounted.

### REFERENCE SIGNS LIST

- 1: substrate
- 2: base
- 2a: one main surface
- 3, 3A-3F: pad
- 30: surface
- 30A-30S: non-resist region
- 31: edge
- 6: solder resist
- 61, 62: extending resist (first extending resist)
- 63, 64: second extending resist
- 7: mark layer
- 8: hole
- 10: electronic component
- 11: heat dissipation portion
- 13A-13C: solder
- 100: module

## Claims

1. A substrate comprising:
a plate-shaped base;
a pad provided on one main surface of the base and containing metal; and
a solder resist provided on a part of a surface of the pad;
wherein
a plurality of holes penetrating the pad and the base in a thickness direction of the base is formed at a position different from a position where the solder resist is provided on the pad, and
the solder resist extends between the plurality of holes without overlapping the plurality of holes and is in contact with an edge of the pad in a plan view seen along the thickness direction of the base.

2. The substrate according to claim 1, wherein
the solder resist is in contact with the edge of the pad at two or more places in the plan view,
a region of the surface of the pad where the solder resist is not disposed is sectioned into a plurality of non-resist regions by the solder resist, and
the plurality of holes is formed in at least two of the plurality of non-resist regions.

3. The substrate according to claim 2, wherein
the solder resist has a plurality of extending resists extending along one direction without intersecting each other in the plan view and being in contact with the edge of the pad at opposite ends, and
the plurality of extending resists and the plurality of non-resist regions are alternately positioned in the plan view.

4. The substrate according to claim 2, wherein
the solder resist includes:
a plurality of first extending resists extending along a first direction without intersecting each other in the plan view and being in contact with the edge of the pad at opposite ends; and
a plurality of second extending resists extending along a second direction different from the first direction without intersecting with each other in the plan view and being in contact with the edge of the pad at opposite ends, and
the plurality of first extending resists and the plurality of second extending resists intersect with each other.

5. The substrate according to any one of claims 1 to 4, wherein a mark layer constituting a mark is provided on the solder resist.

6. A module comprising:
the substrate according to any one of claims 1 to 5;
an electronic component mounted on the substrate and having a heat dissipation portion opposite to the pad; and
a solder disposed between the heat dissipation portion of the electronic component and the pad of the substrate and inside at least one of the plurality of holes to connect the heat dissipation portion and the pad.
